# DEMANDE DE BREVET EUROPEEN

(11) **EP 4 848 935 A1**
(43) Date de publication de la demande: **02.12.2026**
(21) Numéro de dépôt: 26179311.1
(22) Date de dépôt: 18.05.2026
(51) Int. Cl.: H10D 30/65, H10D 62/10

(54) **STRUCTURE DE TRANSISTOR DE DÉTECTION**

(30) Priorité: 27.05.2025 FR 2505722
(71) Demandeur: STMicroelectronics International N.V., 1228 Plan-les-Ouates, Geneva (CH)
(72) Inventeur: MASOERO, Lia, 13006 MARSEILLE (FR); RUGGERI, Marina, 13100 AIX-EN-PROVENCE (FR)
(74) Mandataire: Cabinet Beaumont

(57) **Abrégé**

La présente description concerne une structure de transistor de détection (400) comprenant une pluralité de cellules de transistor situées dans des zones actives (23, 43) d'un premier type de conductivité séparées les unes des autres par des tranchées intérieures (210), les cellules de transistor comprenant :
- des premières cellules de transistor (42) situées sur des bords longitudinaux de la structure de transistor de détection, chacune comprenant une première région de contact (409) du deuxième type de conductivité dans une première région de corps (404), un premier contact (435) sur la première région de contact, et une première région LDD (406) ; et
- des deuxièmes cellules de transistor (21) entre les premières cellules de transistor, chacune comprenant une région de drain (207) dans une deuxième région LDD (206), une région de source (205) dans une deuxième région de corps (204), les régions de drain et de source étant du premier type de conductivité, un contact de source (235) sur la région de source et un contact de drain (237) sur la région de drain ;
les premières et deuxièmes LDD étant du premier type de conductivité et les régions de corps du deuxième type de conductivité, étant toutes dans les zones actives ; et
- des régions de grille (214) dans les tranchées intérieures entre les régions de corps.

## Description

### Domaine technique

La présente description concerne de façon générale les dispositifs électroniques et, plus particulièrement, les dispositifs électroniques comportant une structure de transistor de détection.

La présente description peut particulièrement viser une structure MOSFET de détection.

### Technique antérieure

Une structure de transistor de détection, par exemple une structure MOSFET de détection, est dédiée à la détection d'un courant circulant dans une structure principale de transistor, sur la base d'un courant circulant dans la structure de transistor de détection. Par conséquent, le courant qui circule dans la structure de transistor de détection doit de préférence être représentatif du courant qui circule dans la structure principale de transistor.

Une structure de transistor de détection peut être appelée en anglais "sense FET", détecteur FET.

Parmi les applications d'une structure de transistor de détection, on trouve la détection d'une surtension, d'un court-circuit, d'une charge ouverte ou d'autres conditions dangereuses pouvant survenir sur une structure principale de transistor.

### Résumé de l'invention

Il existe un besoin d'améliorer au moins certains aspects des structures de transistor de détection, par exemple pour réduire les problèmes de déviation du courant et de dérive du courant dans une structure de transistor de détection, qui peuvent fausser l'équivalence de courant avec celui de la structure principale de transistor.

Un mode de réalisation pallie tout ou partie des inconvénients des structures connues de transistor de détection.

Un mode de réalisation prévoit une structure de transistor de détection dédiée à la détection d'un courant circulant dans une structure principale de transistor, la structure de transistor de détection comprenant une pluralité de cellules de transistor situées au moins dans des zones actives formées dans une première couche semiconductrice d'un premier type de conductivité s'étendant dans un plan, chaque cellule de transistor comprenant une région de drain à faible diffusion, LDD, de l'anglais "light diffusion drain", du premier type de conductivité et une région de corps du deuxième type de conductivité opposé au premier type de conductivité ;
les régions LDD et de corps étant situées dans les zones actives, affleurant une première face de la première couche semiconductrice, et étant séparées les unes des autres dans une première direction du plan, les zones actives étant séparées les unes des autres dans une deuxième direction du plan, sensiblement orthogonale à la première direction, par des tranchées intérieures qui s'étendent à partir de la première face dans la première couche semiconductrice ; les cellules de transistor comprenant :
- des premières cellules de transistor situées sur des bords longitudinaux, s'étendant dans la première direction, de la structure de transistor de détection, chaque première cellule de transistor comprenant une première région de contact dans une première région de corps parmi les régions de corps, un premier contact sur la première région de contact, et une première région LDD parmi les régions LDD, la première région de contact affleurant la première face et étant plus fortement dopée du deuxième type de conductivité que la première région de corps ; et
- des deuxièmes cellules de transistor positionnées entre les premières cellules de transistor dans la deuxième direction, chaque deuxième cellule de transistor comprenant une région de drain implantée dans une deuxième région LDD parmi les régions LDD, une région de source implantée dans une deuxième région de corps parmi les régions de corps, les régions de drain et de source étant implantées à partir de la première face et étant plus fortement dopées du premier type de conductivité que respectivement la deuxième région LDD et la deuxième région de corps, un contact de source sur la région de source et un contact de drain sur la région de drain ; les cellules de transistor comportant en outre des régions de grille dans les tranchées intérieures entre les régions de corps adjacentes dans la deuxième direction.

Dans un mode de réalisation, les premières cellules de transistor ne comportent ni régions de source dans les premières régions de corps, ni régions de drain dans les premières régions LDD.

Dans un mode de réalisation, les premières cellules de transistor ne comportent pas de contacts de drain sur les premières régions LDD.

Dans un mode de réalisation, les cellules de transistor sont allongées dans la première direction.

Dans un mode de réalisation, chaque deuxième cellule de transistor comprend en outre une deuxième région de contact dans la deuxième région de corps, la deuxième région de contact affleurant la première face et étant plus fortement dopée du deuxième type de conductivité que la deuxième région de corps.

Dans un mode de réalisation, les deuxièmes cellules de transistor adjacentes dans la deuxième direction ont une deuxième région de corps commune, une région de source commune, une deuxième région LDD commune, une région de drain commune et une région de grille commune ; et les première et deuxième cellules de transistor adjacentes dans la deuxième direction ont une région de grille commune.

Dans un mode de réalisation, la structure du transistor de détection comporte en outre une tranchée extérieure située autour des zones actives et des tranchées intérieures et reliée aux tranchées intérieures, la tranchée extérieure comportant un élément conducteur entouré d'une couche isolante.

Dans un mode de réalisation, la région de grille est entourée dans chaque tranchée intérieure d'une couche isolante de grille.

Dans un mode de réalisation, chaque tranchée intérieure comprend un élément conducteur entouré d'une couche isolante, l'élément conducteur se trouvant sous la région de grille entre les régions de corps adjacentes dans la deuxième direction et s'étendant jusqu'à la première face de la première région semiconductrice entre les régions LDD adjacentes dans la deuxième direction.

Dans un mode de réalisation, une portion isolante est placée entre l'élément conducteur et la région de grille dans chaque tranchée intérieure.

Dans un mode de réalisation particulier, la portion isolante est de la même épaisseur et/ou d'un même matériau que la couche isolante de grille.

Dans un mode de réalisation, la structure du transistor de détection comprend en outre une deuxième couche semiconductrice du deuxième type de conductivité sous la première couche semiconductrice, par exemple entre la première couche semiconductrice et un substrat semiconducteur du premier type de conductivité.

Dans un mode de réalisation, les tranchées intérieures s'étendent jusqu'à la deuxième couche semiconductrice.

Dans un mode de réalisation, les tranchées intérieures s'arrêtent dans la première couche semiconductrice.

Dans un mode de réalisation, les cellules de transistor sont des cellules de transistor MOS à effet de champ à diffusion latérale en tranchée, TLDMOS.

Un mode de réalisation prévoit un dispositif électronique comprenant :
- une structure de transistor de détection similaire à l'une quelconque des structures de transistor de détection décrites ci-dessus ; et
- une structure principale de transistor reliée en parallèle à la structure de transistor de détection.

Un mode de réalisation prévoit un procédé d'utilisation d'une structure de transistor de détection similaire à l'une quelconque des structures de transistor de détection décrites ci-dessus pour la détection d'un courant circulant dans une structure principale de transistor reliée en parallèle avec la structure de transistor de détection, le procédé d'utilisation comprenant :
- la mesure d'un premier courant circulant dans la structure de transistor de détection ; et
- la déduction à partir du premier courant d'un deuxième courant circulant dans la structure principale du transistor.

Un mode de réalisation prévoit un procédé d'utilisation d'une structure de transistor de détection pour la détection d'un courant circulant dans une structure principale de transistor, le procédé d'utilisation comprenant :
- le couplage de la structure de transistor de détection en parallèle avec la structure principale de transistor, dans lequel la structure de transistor de détection comprend une pluralité de premières cellules de transistor et de deuxièmes cellules de transistor situées dans des zones actives formées dans une première couche semiconductrice d'un premier type de conductivité s'étendant dans un plan, chacune des premières et deuxièmes cellules de transistor comprenant une région de drain à faible diffusion, LDD, du premier type de conductivité et une région de corps du deuxième type de conductivité opposé au premier type de conductivité ;
   les régions LDD et de corps étant situées dans les zones actives qui affleurent une première face de la première couche semiconductrice et sont séparées les unes des autres dans une première direction du plan, les zones actives étant séparées les unes des autres dans une deuxième direction du plan, sensiblement orthogonale à la première direction, par des tranchées intérieures qui s'étendent à partir de la première face dans la première couche semiconductrice ;
   les premières cellules de transistor étant situées sur des bords longitudinaux, s'étendant dans la première direction, de la structure de transistor de détection, chaque première cellule de transistor comprenant une première région de contact dans une première région de corps parmi les régions de corps, un premier contact sur la première région de contact, et une première région LDD parmi les régions LDD, la première région de contact affleurant la première face et étant plus fortement dopée du deuxième type de conductivité que la première région de corps ; et
   les deuxièmes cellules de transistor étant positionnées entre les premières cellules de transistor dans la deuxième direction, chaque deuxième cellule de transistor comprenant une région de drain implantée dans une deuxième région LDD parmi les régions LDD, une région de source implantée dans une deuxième région de corps parmi les régions de corps, les régions de drain et de source étant implantées à partir de la première face de la première couche semiconductrice et étant plus fortement dopées du premier type de conductivité que respectivement la deuxième région LDD et la deuxième région de corps, un contact de source sur la région de source et un contact de drain sur la région de drain ;
- l'utilisation de régions de grille situées dans les tranchées intérieures entre les régions de corps adjacentes dans la deuxième direction pour commander un premier courant dans les premières et deuxièmes cellules de transistor, permettant ainsi une reproduction précise d'un deuxième courant circulant dans la structure principale de transistor ; et
- la mise en œuvre d'une étape de rétroaction sur la base du premier courant détecté par la structure de transistor de détection pour régler le fonctionnement de la structure principale de transistor, empêchant ainsi des conditions de surtension et améliorant la sécurité et la fiabilité de la structure principale de transistor.

Un mode de réalisation prévoit un procédé de fabrication d'une structure de transistor de détection dédiée à la détection d'un courant circulant dans une structure principale de transistor, le procédé de fabrication comprenant :
- la formation de tranchées intérieures à partir d'une première face de, et à travers, une couche semiconductrice d'un premier type de conductivité s'étendant dans un plan, ayant une première direction et une deuxième direction sensiblement orthogonale à la première direction, formant ainsi, dans la couche semiconductrice, des zones actives séparées les unes des autres dans la deuxième direction par les tranchées intérieures ;
- la formation, dans les zones actives, d'une pluralité de premières cellules de transistor sur des bords longitudinaux, s'étendant dans la première direction, de la structure de transistor de détection et de deuxièmes cellules de transistor entre les premières cellules de transistor dans la deuxième direction ;
dans laquelle la formation des premières et deuxièmes cellules de transistor comprend :
la formation, dans chacune des premières et deuxièmes cellules de transistor et dans les zones actives, d'une région LDD du premier type de conductivité et d'une région de corps du deuxième type de conductivité opposé au premier type de conductivité, chacune affleurant la première face et séparée l'une de l'autre dans la première direction ;
l'implantation, dans chacune des premières cellules de transistor, d'une première région de contact affleurant la première face dans une première région de corps parmi les régions de corps, avec un dopage du deuxième type de conductivité plus important que la première région de corps, et la formation d'un premier contact sur chaque première région de contact ;
l'implantation, dans chacune des deuxièmes cellules de transistor, d'une région de drain affleurant la première face dans une deuxième région LDD parmi les régions LDD, avec un dopage du premier type de conductivité plus important que la deuxième région LDD, et d'une région de source affleurant la première face dans une deuxième région de corps parmi les régions de corps, avec un dopage du premier type de conductivité plus important que la deuxième région de corps, et la formation d'un contact de source sur la région de source et d'un contact de drain sur la région de drain ;
- l'intégration de régions de grille dans les tranchées intérieures entre les régions de corps adjacentes dans la deuxième direction pour commander l'état de conduction des premières et deuxièmes cellules de transistor.

Selon un mode de réalisation, le procédé de fabrication comprend en outre le montage de la structure de transistor de détection en parallèle avec la structure principale de transistor, le couplage électrique des régions de grille de la structure de transistor de détection et de la structure principale de transistor et le couplage électrique des régions de drain de la structure de transistor de détection et de la structure principale de transistor afin de faciliter la détection du courant et la protection de la structure principale de transistor.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A et la figure 1B sont des vues de dessus simplifiées qui représentent un exemple d'un dispositif électronique comprenant une structure de transistor de détection et une structure principale de transistor ;
la figure 2A est une vue de dessus simplifiée qui représente une structure de transistor de détection ;
la figure 2B est une vue tridimensionnelle qui représente une cellule de transistor centrale de la structure de transistor de détection de la figure 2A ;
la figure 2C est une vue tridimensionnelle qui représente une cellule de transistor latérale de la structure de transistor de détection de la figure 2A ;
la figure 2D est une vue tridimensionnelle qui représente des cellules de transistor centrale et latérale adjacentes de la structure de transistor de détection de la figure 2A ;
la figure 2E et la figure 2F sont vues en coupes transversales différentes qui représentent une tranchée intérieure de la structure du transistor de détection de la figure 2A ;
la figure 2G est une vue en coupe transversale qui représente une tranchée extérieure de la structure de transistor de détection de la figure 2A ;
la figure 3A montre des courbes qui représentent le courant d'une cellule de transistor centrale en fonction de la température et le courant d'une cellule de transistor latérale en fonction de la température ;
la figure 3B montre une courbe qui représente la dérive du courant d'une cellule de transistor latérale en fonction de la température ;
la figure 4A est une vue de dessus qui représente une structure de transistor de détection selon un mode de réalisation ;
la figure 4B est une vue tridimensionnelle qui représente des cellules de transistor centrale et latérale adjacentes d'une structure de transistor de détection selon un mode de réalisation ; et
la figure 5 montre des courbes qui représentent la dérive du courant en fonction de la température dans une cellule de transistor latérale d'une structure de transistor de détection selon un mode de réalisation, comparée à une structure de transistor de détection de l'état de l'art.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les étapes de fabrication de la structure principale de transistor et de la structure de transistor de détection et des cellules de transistor ne sont pas décrites, étant donné qu'elles peuvent être mises en œuvre à l'aide de procédés classiques de la microélectronique. De même, tous les détails de la structure principale de transistor et de la structure de transistor de détection et des cellules de transistor n'ont pas été décrits, car ils sont à la portée de la personne du métier dans le domaine des transistors.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % ou 10° près, de préférence à 5 % ou 5° près.

Dans la description qui suit, lorsqu'il est fait référence à une "zone active", il est fait référence à une zone semiconductrice d'au moins un transistor, par exemple délimitée par une ou plusieurs tranchées. Dans des transistors à diffusion latérale, une zone active comprend généralement au moins une région de source, au moins une région de drain et au moins une région de canal, entre les régions de source et de drain adjacentes. La zone active peut être formée dans un substrat semiconducteur, dans un caisson formé dans un substrat semiconducteur ou dans une couche semiconductrice formée sur le substrat semiconducteur.

Dans la description qui suit, lorsqu'il est fait référence à un "substrat", il s'agit d'un substrat semiconducteur, et lorsqu'il est fait référence à une "région", il s'agit d'une région semiconductrice, à l'exception d'une région de grille qui peut être une région métallique et/ou semiconductrice.

Dans la description qui suit, une longueur correspond à une dimension dans une première direction, correspondant à la direction X indiquée dans les dessins, d'un plan principal XY. La première direction est parallèle à la direction de conduction des transistors. Une longueur d'un canal d'un transistor correspond essentiellement à la distance entre une région de source et une région de drain du transistor. Une largeur correspond à une dimension dans une deuxième direction du plan principal, orthogonale à la direction X, correspondant à la direction Y indiquée dans les dessins. Une épaisseur ou une profondeur correspond à une dimension dans la direction perpendiculaire au plan principal, par exemple une direction verticale, correspondant à la direction Z indiquée dans les dessins. Le terme "transversal" se réfère à la direction de la largeur (direction Y) et le terme "longitudinal" ou "latérale" se réfère à la direction de la longueur (direction X).

Dans la description qui suit, lorsqu'il est fait référence à un élément conducteur, il s'agit d'un élément conducteur électriquement. De même, lorsqu'il est fait référence à un élément isolant ou d'isolation, il s'agit d'un élément isolant électriquement.

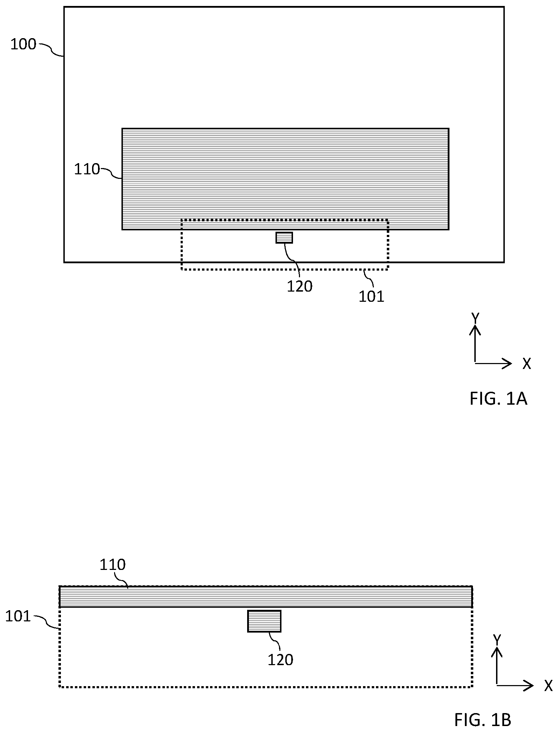

La figure 1A et la figure 1B sont des vues de dessus simplifiées qui représentent un exemple d'un dispositif électronique 100 comprenant une région principale de transistor 110 et une région de transistor de détection 120. La figure 1B représente une partie agrandie 101 du dispositif électronique 100.

Le dispositif électronique 100 peut être un circuit intégré. Le dispositif électronique 100 est défini par un substrat semiconducteur et des composants électroniques situés à l'intérieur et au-dessus du substrat semiconducteur.

Le substrat semiconducteur peut être constitué d'une plaquette semiconductrice, par exemple une plaquette de silicium. Le substrat semiconducteur peut comprendre une couche située à une surface d'une plaquette semiconductrice, par exemple une couche épitaxiale sur une plaquette semiconductrice.

Parmi les composants électroniques, le dispositif électronique 100 comprend une pluralité de transistors, qui peuvent être appelés cellules de transistor.

Chaque cellule de transistor peut être fabriquée par une technologie CMOS, de l'anglais "Complementary Metal Oxide Semiconductor", semiconducteur oxyde métal complémentaire, et est de préférence un "MOSFET", de l'anglais "Metal Oxide Semiconductor Field Effect Transistor", transistor à effet de champ à semiconducteur à oxyde métallique. Un MOSFET peut également être appelé transistor MOS. Un transistor NMOS est un transistor MOS à canal N, c'est-à-dire un transistor dont les régions de source et de drain sont dopées de type N. Un transistor PMOS est un transistor MOS à canal P, c'est-à-dire un transistor dont les régions de source et de drain sont dopées de type P.

Le dispositif électronique 100 comprend différentes régions. Parmi ces différentes régions, le dispositif électronique 100 comprend au moins une région principale de transistor 110 et une région de transistor de détection 120.

Par exemple, la région principale de transistor 110 a une forme rectangulaire, et la région de transistor de détection 120 a également une forme rectangulaire et est disposée à proximité de la région principale de transistor 110, par exemple à proximité d'un bord longitudinal de la région principale de transistor 110. La région principale de transistor 110 a une surface plus grande que la surface de la région de transistor de détection 120, par exemple plus de 10 000 fois plus grande, voire plus.

Dans les deux région principale de transistor 110 et région de transistor de détection 120, des MOSFET ayant la même structure sont formés. Les MOSFET sont de préférence des MOSFET à diffusion latérale en tranchée (TLDMOS, de l'anglais "Trench Lateral Diffusion MOS").

La région principale de transistor 110 est de préférence reliée en parallèle avec la région de transistor de détection 120. De préférence, les grilles, respectivement les drains, des MOSFET de la région principale de transistor 110 sont court-circuitées avec les grilles, respectivement les drains, des MOSFET de la région de transistor de détection 120.

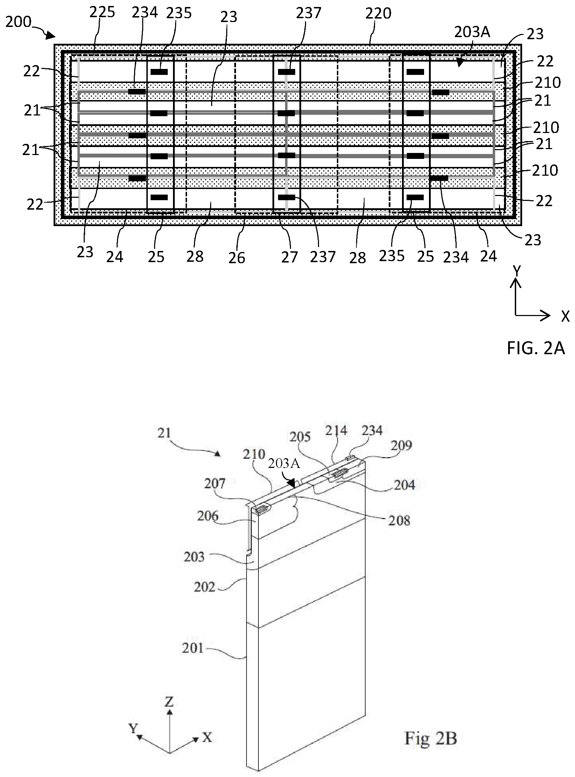

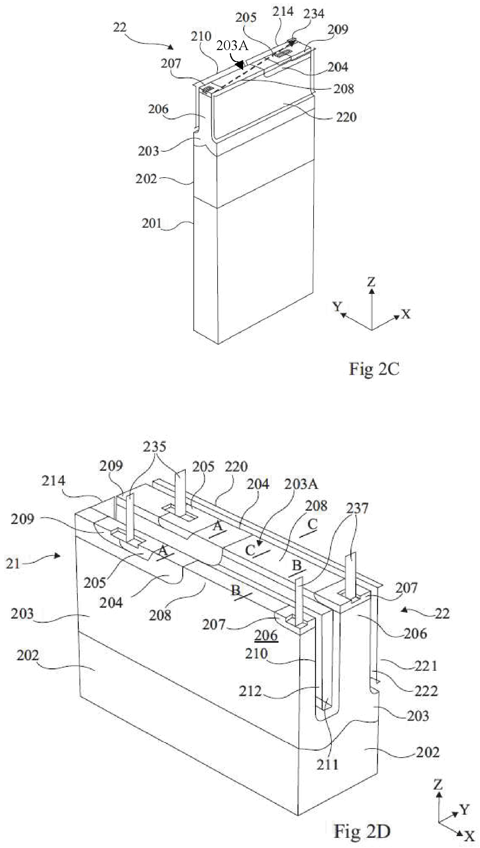

La figure 2A est une vue de dessus simplifiée qui représente une structure de transistor de détection 200. La structure de transistor de détection 200 peut être mise en œuvre dans une région de transistor de détection, telle que la région de transistor de détection 120 des figures 1A et 1B. La figure 2B est une vue tridimensionnelle qui représente une cellule de transistor centrale 21 de la structure de transistor de détection 200 de la figure 2A. La figure 2C est une vue tridimensionnelle qui représente une cellule de transistor latérale 22 de la structure de transistor de détection 200 de la figure 2A. La figure 2D est une vue tridimensionnelle qui représente les cellules de transistor centrale 21 et latérale 22 adjacentes de la structure de transistor de détection 200 de la figure 2A.

La structure de transistor de détection 200 comprend une pluralité de transistors élémentaires 21, 22, appelés cellules de transistor, formés dans et/ou sur un substrat semiconducteur 201. Dans l'exemple représenté dans les figures 2A à 2D, les transistors sont des MOSFET à diffusion latérale en tranchée (TLDMOS), mais cela n'est pas limitatif et les transistors pourraient être d'autres types de MOSFET ayant une conduction de canal en tranchée et comprenant des tranchées d'isolation, par exemple des MOSFET à grille verticale en tranchée.

La structure de transistor de détection représentée 200 peut être une partie d'une structure de transistor de détection plus grande.

Le substrat semiconducteur 201 est d'un premier type de conductivité.

Dans un exemple, le substrat semiconducteur 201 est constitué d'une plaquette semiconductrice, par exemple une plaquette de silicium.

La structure du transistor de détection 200 comprend différentes zones, certaines d'entre elles étant délimitées par un cadre en traits pointillés ou en trait continu :
- des zones de corps 24 (cadre en traits pointillés) ;
- des zones de source 25 (cadre en trait continu) positionnées dans des parties supérieures des zones de corps 24 ;
- une zone LDD (de l'anglais "Light Diffusion Drain", drain à faible diffusion) 26 (cadre en traits pointillés), positionnée entre les zones de corps 24 ;
- une zone de drain 27 (cadre en trait continu), positionnée sur une partie supérieure de la zone LDD 26 ;
- des zones de dérive 28 (en anglais "drift areas"), entre la zone LDD 26 et chacune des zones de corps 24.

Les différentes zones 24, 25, 26, 27, 28 sont situées sur des faces supérieures, ou faces avant, de zones actives 23.

Les zones actives 23 sont formées dans une couche semiconductrice 203 du premier type de conductivité, le type N dans l'exemple des figures 2B à 2D. La couche semiconductrice 203 peut être une région du substrat 201 ou une couche épitaxiale formée sur le substrat 201.

La face supérieure des zones actives 23 correspond à la face supérieure 203A de la couche semiconductrice 203.

Les zones actives 23 adjacentes sont séparées, dans la direction Y, par des tranchées intérieures 210 formées dans la couche semiconductrice 203. Les zones actives 23 et les tranchées intérieures 210 sont sensiblement allongées dans la direction X. Par exemple, les zones actives 23 et les tranchées intérieures 210 sont en forme de bande, mais d'autres formes de zones actives et de tranchées intérieures peuvent être envisagées par la personne du métier.

Dans l'exemple de la figure 2A, il y a quatre zones actives 23 en forme de bande séparées par trois tranchées intérieures 210 en forme de bande, mais d'autres nombres et formes de zones actives et de tranchées intérieures peuvent être envisagés par la personne du métier.

Les zones actives 23 et les tranchées intérieures 210 sont entourées d'une tranchée extérieure 220 qui est reliée aux tranchées intérieures 210, par exemple à l'aide de contacts qui sont court-circuités par une ligne métallique 225. La tranchée extérieure 220 a, par exemple, une forme annulaire sensiblement rectangulaire.

Les tranchées intérieures et extérieures 210, 220 s'étendent sensiblement dans la direction Z à partir de la face supérieure 203A de la couche semiconductrice 203.

La couche semiconductrice 203 est isolée du substrat 201 par une couche semiconductrice 202, ou caisson semiconducteur, du deuxième type de conductivité, le type P dans l'exemple des figures 2B à 2D. La couche semiconductrice 202 est de préférence une région enterrée et peut être appelée anneau (en anglais "ring"), un anneau du type P (en anglais "P-ring") dans l'exemple des figures 2B à 2D.

Les tranchées intérieures et extérieures 210, 220 peuvent s'étendre jusqu'à la couche semiconductrice 202 ou s'arrêter dans la couche semiconductrice 203.

Dans l'exemple des figures 2A à 2D, le premier type de conductivité est le type N et le deuxième type de conductivité est le type P, les transistors MOSFET étant des transistors NMOS.

Dans une variante, le premier type de conductivité peut être le type N et le deuxième type de conductivité le type P, les transistors MOSFET étant des transistors PMOS.

Dans chaque zone active 23, les différentes zones 24, 25, 26, 27, 28 sont définies par des régions semiconductrices qui sont positionnées à la face supérieure 203A de la couche semiconductrice 203.

Dans chaque zone active 23, les régions semiconductrices comprennent :
- une région de corps 204 (en anglais "body region") du deuxième type de conductivité, située dans chacune des zones de corps 24 ;
- une région de source 205 du premier type de conductivité, positionnée dans une partie supérieure de la zone de corps 204 et située dans chacune des zones de source 25 ;
- une région LDD 206 du premier type de conductivité, située dans la zone LDD 26 ;
- une région de drain 207 du premier type de conductivité, positionnée dans une partie supérieure de la région LDD 206 et située dans la zone de drain 27 ;
- une région de dérive 208 du premier type de conductivité, positionnée entre la région LDD 206 et la région de corps 204, et située dans chacune des zones de dérive 28 ;
- une région de contact 209 du deuxième type de conductivité, positionnée dans une autre partie supérieure de chaque région de corps 204.

Les régions de corps 204 forment au moins une partie des régions de canal des MOSFET.

Les régions semiconductrices 204, 205, 206, 207, 208, 209 constituent des parties des cellules de transistor 21, 22 qui comprennent également des régions de grille 214 dans les tranchées intérieures 210, comme cela sera décrit ci-dessous. Les cellules de transistor 21, 22 sont situées dans la couche semiconductrice 203 et sur la face supérieure 203A de la couche semiconductrice 203. En particulier, les régions semiconductrices 204, 205, 206, 207, 208, 209 ne sont de préférence pas recouvertes par une partie du substrat 201, de la couche semiconductrice 203 ou de toute autre couche ou région semiconductrice.

La région LDD 206 a un niveau de dopage inférieur à celui de la région de drain 207, et inférieur à celui de la couche semiconductrice 203.

La région de contact 209 a un niveau de dopage supérieur à celui de la région de corps 204. La région de contact 209 peut former un contact électrique pour la région de corps 204 et peut être appelée région de contact de corps.

La région de source 205 est par exemple positionnée entre la région de corps 204 et la région de contact 209, mais d'autres configurations peuvent être envisagées par la personne du métier.

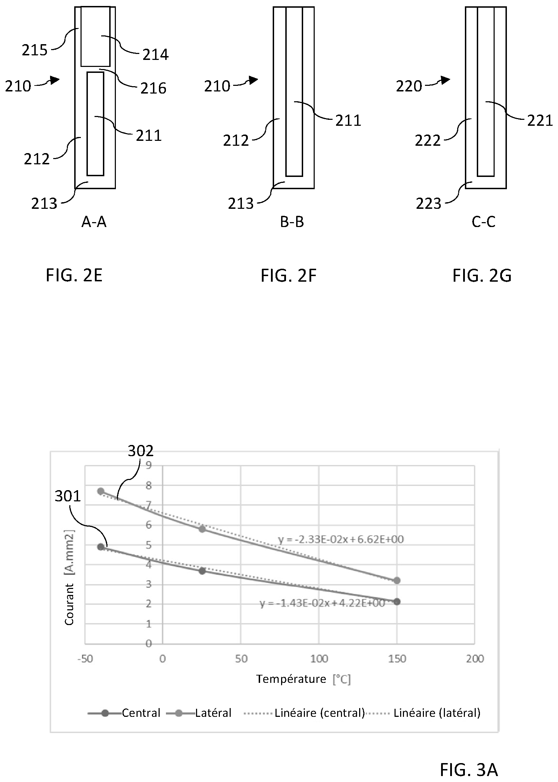

La figure 2E et la figure 2F sont des vues en coupes transversales différentes qui représentent une tranchée intérieure 210 de la structure de transistor de détection 200 de la figure 2A. La figure 2G est une coupe transversale qui représente une tranchée extérieure 220 de la structure de transistor de détection 200 de la figure 2A. Les figures 2E, 2F, 2G correspondent aux plans de coupe transversale respectifs A-A, B-B, C-C de la figure 2D.

Un élément conducteur 211 est situé dans la tranchée intérieure 210. L'élément conducteur 211 comprend, de préférence est constitué de, un matériau métallique ou, de préférence, du silicium polycristallin dopé. La largeur de l'élément conducteur 211, dans le sens de la largeur de la tranchée intérieure 210, est par exemple dans la plage allant de 30 nm à 400 nm. De préférence, l'élément conducteur 211 est une paroi conductrice située dans une partie centrale de la tranchée intérieure 210, la paroi conductrice s'étendant dans la même direction que la tranchée intérieure 210. La largeur de la tranchée intérieure 210 est par exemple égale à environ 600 nm.

L'élément conducteur 211 est entouré d'une couche isolante 212. La couche isolante 212 isole au moins l'élément conducteur 211 de la couche semiconductrice 203. L'épaisseur de la couche isolante 212 est par exemple dans la plage allant de 100 nm à 200 nm, par exemple égale à environ 160 nm. À titre d'exemple, la couche isolante 212 est constituée d'oxyde de silicium ou de nitrure de silicium.

Au fond de la tranchée intérieure 210, une partie isolante 213, de préférence une partie de la couche isolante 212, est située sous l'élément conducteur 211. Cette partie isolante 213 isole également l'élément conducteur 211 de la couche semiconductrice 203 située sous l'élément conducteur 211. L'épaisseur de la partie isolante 213 est de préférence similaire à celle de la couche isolante 212.

Comme cela est représenté en figure 2E, entre les régions de corps 204 (dans les zones du corps et de source 24, 25), une région de grille 214 est positionnée au-dessus de l'élément conducteur 211 dans la tranchée intérieure 210. La région de grille 214 comprend au moins un conducteur électrique tel que, par exemple, un métal et/ou du silicium polycristallin dopé.

La région de grille 214 est entourée d'une couche isolante de grille 215 qui isole au moins la région de grille 214 des régions de corps 204 et généralement aussi de la couche semiconductrice 203. La couche isolante de grille 215 est typiquement constituée d'une ou de plusieurs couches diélectriques, par exemple, la couche isolante de grille 215 est constituée d'une couche d'oxyde de silicium. L'épaisseur de la couche isolante de grille 215 est par exemple comprise entre 3 et 40 nm, par exemple égale à environ 35 nm.

La couche isolante 212 a de préférence une épaisseur supérieure à celle de la couche isolante de grille 215.

En outre, des parties isolantes 216, de préférence de la même épaisseur et en un même matériau que la couche isolante de grille 215, isolent l'élément conducteur 211 de la région de grille 214 dans la tranchée intérieure 210.

Comme cela est représenté en figure 2F, entre les régions LDD 206 (dans les zones de LDD et de drain 26, 27), aucune grille n'est positionnée sur l'élément conducteur 211 qui s'étend jusqu'à l'extrémité supérieure de la tranchée intérieure 210.

Comme cela est représenté en figure 2G, un élément conducteur 221 est situé dans la tranchée extérieure 220, entouré d'une couche isolante 222, et, au fond de la tranchée extérieure 220, une portion isolante 223, de préférence une portion de la couche isolante 222, est située sous l'élément conducteur 221. L'élément conducteur 221, la couche isolante 222 et la partie isolante 223 de la tranchée extérieure 220 sont de préférence similaires à ceux de la tranchée intérieure 210. Dans la tranchée extérieure 220, aucune grille n'est placée au-dessus de l'élément conducteur 221 qui s'étend jusqu'à l'extrémité supérieure de la tranchée extérieure 220.

Les éléments conducteurs 211, 221 dans les tranchées 210, 220 peuvent être appelés plaques de champ (FP).

À l'état non conducteur des transistors, les éléments conducteurs 211, 221 font écran à une partie du champ électrique dû à la tension entre la région de canal/corps 204 et la région de drain 207, augmentant la tension maximale que le transistor peut bloquer, sans augmenter la résistance à l'état passant du transistor, grâce à une distribution plus uniforme du champ électrique à la tension de claquage.

Du fait que les régions de grille 214 sont situées dans les tranchées intérieures 210, dans l'état conducteur des transistors, des canaux de conduction sont formés dans les régions de canal/corps 204 contre la surface latérale de ces régions de canal. Par rapport à une structure où les grilles sont disposées sur les régions de canal, on évite que le canal de conduction ait une largeur égale à la distance entre les tranchées intérieures. Ainsi, le fait de prévoir les régions de grille 214 dans les tranchées intérieures 210 permet à la forme du canal de conduction de dépendre uniquement de l'extension des régions de grille 214 dans les tranchées intérieures 210 et sur les régions de canal 204. La distance entre les tranchées intérieures peut donc être réduite, par exemple, les tranchées intérieures peuvent être rapprochées l'une de l'autre, sans modifier la forme du canal de conduction, par exemple, sans diminuer sa largeur. L'utilisation de grilles dans les tranchées intérieures permet d'intégrer plus de régions de canal dans la même zone, ce qui augmente le courant circulant dans les transistors, sans augmenter la résistance à l'état passant des transistors. La surface occupée par chaque transistor peut être, pour un même courant et une même résistance à l'état passant, inférieure à celle d'un transistor dont la grille est située sur la région de canal.

Les éléments conducteurs 211 et les régions de grille 214 situés dans les tranchées intérieures 210 provoquent, dans chaque transistor à l'état conducteur, la circulation du courant dans une partie de la région LDD 206 plus importante qu'en l'absence d'éléments conducteurs et si les grilles n'étaient pas situées dans les tranchées 210. En particulier, le courant circule dans des parties des régions LDD 206 plus éloignées des surfaces latérales des régions LDD 206 qu'en l'absence des éléments conducteurs 211. Le courant circule également dans des parties des régions LDD 206 plus éloignées des faces supérieures des régions LDD 206 que si les grilles étaient situées sur les régions de canal. Cela permet de diminuer la résistance à l'état passant des transistors.

Des contacts de grille 234 sont situés sur les régions de grille 214. Des contacts de source 235 sont situés sur les régions de source 205. Des contacts de drain 237 sont situés sur les régions de drain 207.

Les contacts 234, 235, 237 peuvent relier électriquement les transistors à d'autres composants du dispositif électronique ou à un dispositif externe.

Les cellules de transistor 21, 22 comprennent des cellules de transistor centrales 21 et des cellules de transistor latérales 22. Les cellules de transistor latérales 22 sont positionnées sur des bords longitudinaux de la structure de transistor de détection 200, c'est-à-dire sur les bords longitudinaux de la tranchée extérieure 220 (bords s'étendant dans la direction X). Les cellules de transistor latérales 22 peuvent être appelées cellules de transistor de bordure 22. Les cellules de transistor centrales 21 sont positionnées entre les cellules de transistor latérales 22 dans la direction Y.

La couche semiconductrice 202 est de préférence commune aux cellules de transistor centrales et latérales 21, 22.

Comme cela est représenté dans l'exemple des figures 2A à 2D, des cellules de transistor centrales 21 adjacentes dans la direction Y peuvent partager une même zone active 23, et donc de mêmes région de corps/canal 204, région de source 205, région LDD 206, région de drain 207, région de dérive 208 et région de contact 209. Comme cela est représenté dans l'exemple des figures 2A à 2D, chaque cellule de transistor latérale 22 peut avoir sa propre zone active 23, et donc ses propres région de corps/canal 204, région de source 205, région LDD 206, région de drain 207, région de dérive 208 et région de contact 209. Par conséquent, la largeur de la zone active 23 de chaque cellule de transistor latérale 22 peut être doublée par rapport à la largeur de la zone active 23 de chaque cellule de transistor centrale 21, et/ou être sensiblement égale à la largeur des zones actives 23 de deux cellules de transistor centrales 21 adjacentes. De plus, des cellules de transistor centrales 21 adjacentes dans la direction Y partagent une même tranchée intérieure 210, et donc une même région de grille 214 et un même élément conducteur 211, et chaque cellule de transistor latérale 22 partage une même tranchée intérieure 210, et donc une même région de grille 214 et un même élément conducteur 211, avec une cellule de transistor centrale 21 adjacente dans la direction Y. Chaque cellule de transistor latérale 22 comporte en outre au moins une partie latérale d'une tranchée extérieure 220. Par conséquent, chaque cellule de transistor latérale 22 comprend une région de grille 214 et un élément conducteur 211 dans une tranchée intérieure 210 d'un côté, et seulement un élément conducteur 221 dans une tranchée extérieure 220 de l'autre côté.

Comme cela est représenté dans l'exemple de la figure 2A, les cellules de transistor centrales 21 adjacentes dans la direction Y peuvent partager de mêmes contacts de grille, de source et de drain 234, 235, 237, et des cellules de transistor centrale et latérale 21, 22 adjacentes dans la direction Y peuvent partager un même contact de grille 234. D'autres configurations peuvent être envisagées par la personne du métier.

Les cellules de transistor centrales 21 peuvent être également adjacentes les unes aux autres dans la direction X. De même, les cellules de transistor latérales 22 peuvent être également adjacentes les unes aux autres dans la direction X.

Dans l'exemple représenté en figure 2A, la structure de transistor de détection 200 comprend deux colonnes (dans la direction Y) de cellules de transistor centrales et latérales 21, 22, chaque colonne comprenant six lignes (dans la direction X) comprenant quatre cellules de transistor centrales 21 entre deux cellules de transistor latérales 22. Cet exemple de structure de transistor de détection n'est pas limitatif et tout autre nombre de colonnes et/ou de lignes, c'est-à-dire de cellules de transistor centrales entre les cellules de transistor latérales dans une colonne, peut être envisagé par la personne du métier.

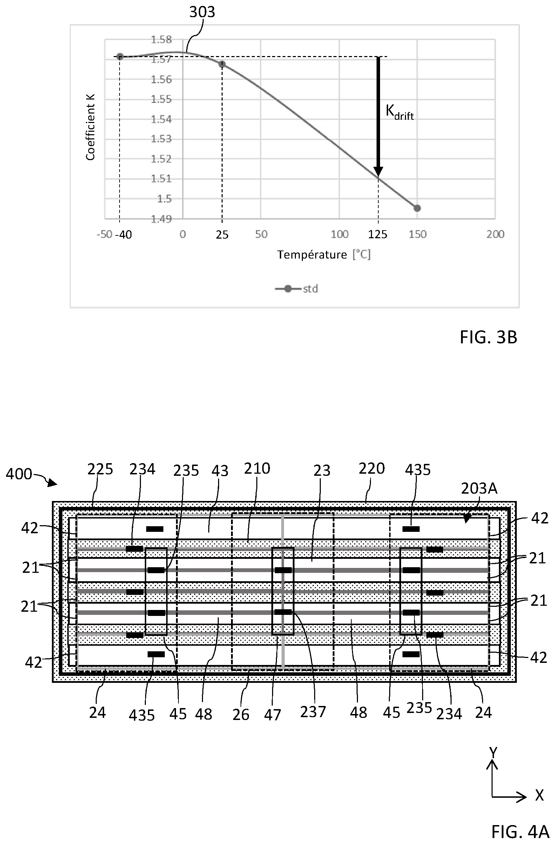

La figure 3A montre des courbes qui représentent le courant d'une cellule de transistor centrale en fonction de la température et le courant d'une cellule de transistor latérale en fonction de la température. La courbe 301 représente la cellule de transistor centrale. La courbe 302 représente la cellule de transistor latérale. La figure 3B montre une courbe 303 qui représente la dérive du courant d'une cellule de transistor latérale en fonction de la température.

Le rôle d'une structure de transistor de détection 200 est de conduire un courant ayant un rapport donné par rapport au courant qui circule dans la structure principale de transistor pour toutes les conditions de fonctionnement en termes de plage de courant et de plage de température, par exemple entre -40°C et 150°C. Idéalement, le rapport électrique K_{electric} entre le courant Iₘₐᵢₙ qui circule dans la structure principale de transistor et le courant Iₛₑₙₛₑ qui circule dans la structure de transistor de détection devrait être sensiblement le même que le rapport géométrique K_{geometric} entre la surface Aₘₐᵢₙ de la structure principale de transistor et la surface Aₛₑₙₛₑ de la structure de transistor de détection. En d'autres termes, dans l'idéal, le rapport K_{ratioN} entre le rapport électrique K_{electric} et le rapport géométrique K_{geometric} est sensiblement égal à 1.

Cependant, les inventeurs ont déterminé que, pour la structure de transistor de détection 200, le rapport électrique K_{electric} n'est pas aligné avec le rapport géométrique K_{geometric}. Par exemple, avec un rapport géométrique K_{geometric} de 18 750, ils ont mesuré un rapport électrique K_{electric} d'environ 24 000. En d'autres termes, le rapport K_{ratioN} entre le rapport électrique K_{electric} et le rapport géométrique K_{geometric} est différent de 1.

De plus, les inventeurs ont déterminé par simulation que le courant conduit par les cellules de transistor latérales est environ 1,5 fois plus élevé que le courant conduit par les cellules de transistor centrales, comme l'illustre la figure 3A en comparant la courbe 302 à la courbe 301. La dérive du courant en température dans la cellule de transistor latérale est également plus importante que dans la cellule de transistor centrale, comme l'illustre la figure 3A en comparant la courbe 302 à la courbe 301. En effet, dans la cellule de transistor latérale, il y a une déviation prononcée du courant dans la direction Y entre la région de drain 207 et la région de source 205, représentée par une flèche en traits pointillés en figure 2C, ce qui induit un comportement du courant différent en fonction de la température dans la cellule de transistor latérale par rapport à la cellule de transistor centrale. Cela peut être dû au fait que la tranchée extérieure 220 ne comporte pas de grille et n'est donc pas polarisée et ne pilote pas le courant au bord de la cellule du transistor latérale le plus proche de la tranchée extérieure 220.

La dérive du courant K_{drift} en température est calculée par la différence entre le K_{ratioN} à -40°C et le K_{ratioN} à 150°C par rapport au K_{ratioN} à 25°C, comme cela est indiqué dans la formule suivante :
${K}_{drift} = \frac{{K}_{ratioN} \left(150°C\right) - {K}_{ratioN} \left(-40°C\right)}{{K}_{ratioN} \left(25°C\right)} ,$
où
${K}_{ratioN} = \frac{{K}_{electric}}{{K}_{geometric}} .$

Comme cela est représenté en figure 3B, la dérive du courant K_{drift} peut atteindre une valeur qui n'est pas comprise dans la plage requise, qui est généralement comprise entre -1 % et +1 %. La valeur calculée à partir de la figure 3B est d'environ -3 %.

Il existe donc un besoin pour une structure de transistor de détection ayant une déviation de courant réduite, un K_{ratioN} proche de, ou égal à, 1, en particulier une dérive du courant réduite en température, de sorte que la structure de transistor de détection puisse avoir un courant représentatif du courant de la structure principale de transistor sur une large plage de températures.

La figure 4A est une vue de dessus qui représente une structure de transistor de détection 400 selon un mode de réalisation.

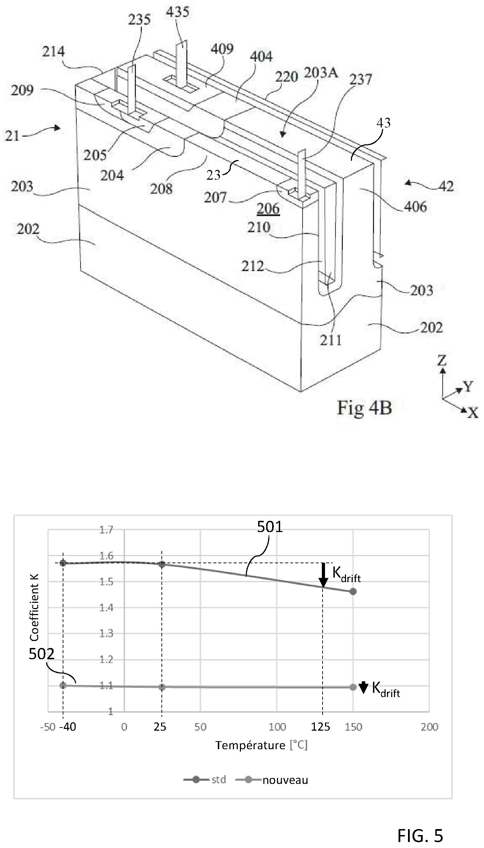

La figure 4B est une vue tridimensionnelle qui représente des cellules de transistor centrale 21 et latérale 42 adjacentes d'une structure de transistor de détection selon un mode de réalisation, par exemple la structure de transistor de détection 400 de la figure 4A.

La structure de transistor de détection 400 de la figure 4A comporte des éléments communs avec la structure de transistor de détection 200 de la figure 2A. Ces éléments communs ont les mêmes signes de référence dans les figures 2A et 4A et ne seront pas décrits à nouveau.

En particulier, les cellules de transistor centrales 210 (deuxièmes cellules de transistor) des figures 4A et 4B sont similaires à celles des figures 2A, 2B et 2D, et ont les mêmes signes de référence.

La structure de transistor de détection 400 de la figure 4A diffère de la structure de transistor de détection 200 de la figure 2A principalement par la structure des cellules de transistor latérales 42, ou cellules de transistor de bordure.

Dans les cellules de transistor latérales 42 (premières cellules de transistor) des figures 4A et 4B, il n'y a pas de région de source du premier type de conductivité implantée dans la région de corps 404, et il n'y a pas de région de drain du premier type de conductivité implantée dans la région LDD 406. Une région de contact 409 est formée dans la région de corps 404.

L'absence de région de drain dans les cellules de transistor latérales 42 permet d'éviter qu'un courant parasite ne circule de la cellule de transistor latérale 42 vers la cellule de transistor centrale 21 adjacente. L'absence de région de source dans les cellules de transistor latérales 42 permet de réduire la déviation du courant dans les cellules de transistor latérales 42. De plus, la présence d'une région de contact 409 dans la région de corps 404 permet de maintenir un potentiel dans la région de corps 404 afin de protéger la région de grille 214.

En d'autres termes, chaque cellule de transistor latérale 42 comprend :
- une région de corps 404 du deuxième type de conductivité, située dans chacune des zones de corps 24 ;
- une région LDD 406 du premier type de conductivité, située dans la zone LDD 26 ;
- une région de contact 409 du deuxième type de conductivité, située dans une partie supérieure de chaque région de corps 404.

La région de contact 409 a un niveau de dopage supérieur à celui de la région de corps 404. La région de contact 409 peut former un contact électrique pour la région de corps 404 (région de contact de corps), le niveau de dopage élevé permettant un meilleur contact électrique par rapport à un niveau de dopage plus faible ou au niveau de dopage de la région de corps 404.

Comme cela est représenté en figure 4B, la région de contact 409 de la cellule de transistor latérale 42 peut être plus longue que la région de contact 209 de la cellule de transistor centrale 21, mais cela n'est pas obligatoire. La région de contact 409 peut être suffisamment longue et large pour être connectée à un contact de corps 435.

Par conséquent, la structure de transistor de détection 400 de la figure 4A diffère également de la structure de transistor de détection 200 de la figure 2A en ce que les zones de source 45, la zone de drain 47 et les zones de dérive 48 ne s'étendent pas dans les cellules de transistor latérales 42.

Les cellules de transistor latérales 42 comprennent également des régions de grille 214 dans les tranchées intérieures 210, de façon similaire à ce qui a été décrit en relation avec les figures 2B à 2D.

Comme dans les figures 2B et 2D, les cellules de transistor 21 (deuxièmes cellules de transistor) comprennent chacune :
- une région de corps 204 du deuxième type de conductivité, située dans chacune des zones de corps 24 ;
- une région de source 205 du premier type de conductivité, positionnée dans une partie supérieure de la région de corps 204 et située dans chacune des zones de source 45 ;
- une région LDD 206 du premier type de conductivité, située dans la zone LDD 26 ;
- une région de drain 207 du premier type de conductivité, positionnée dans une partie supérieure de la région LDD 206 et située dans la zone de drain 47 ;
- une région de dérive 208, du premier type de conductivité, positionnée entre la région de drain 207 et la région de source 205, et située dans chacune des zones de dérive 48 ;
- une région de contact 209 du deuxième type de conductivité, positionnée dans une autre partie supérieure de la région de corps 204.

Les régions de corps 204 forment au moins une partie des régions de canal des MOSFET.

La région LDD 206 a un niveau de dopage inférieur à celui de la région de drain 207. La région de contact 209 a un niveau de dopage supérieur à celui de la région de corps 204. La région de contact 209 peut former un contact électrique pour la région de corps 204 (région de contact de corps) et peut être reliée à la région de source 205. Les régions de source 205 et de corps 204 sont de préférence court-circuitées par un même contact.

La région de source 205 est par exemple positionnée entre la région de corps 204 et la région de contact de corps 209, mais d'autres configurations peuvent être envisagées par la personne du métier.

Les cellules de transistor centrales 21 comprennent également des régions de grille 214 dans les tranchées intérieures 21, de façon similaire à ce qui a été décrit en relation avec les figures 2B à 2D.

De façon similaire à ce qui a été décrit en relation avec les figures 2A à 2D, les cellules de transistor centrales 21 adjacentes dans la direction Y peuvent partager une même zone active 23, et donc de mêmes région de corps 204, région de source 205, région LDD 206, région de drain 207, région de dérive 208 et région de contact 209. De plus, chaque cellule de transistor latérale 42 peut avoir sa propre zone active 43 et donc ses propres région de corps 204, région LDD 406 et région de contact 409. Par conséquent, la largeur de la zone active 43 de chaque cellule de transistor latérale 42 peut être doublée par rapport à la largeur de la zone active 23 de chaque cellule de transistor centrale 21, et/ou sensiblement égale à la largeur des zones actives 23 de deux cellules de transistor centrales 21 adjacentes. Des cellules de transistor 21 adjacentes dans la direction Y partagent une même tranchée intérieure 210, et donc une même région de grille 214 et un même élément conducteur 211. Chaque cellule de transistor latérale 42 partage une même tranchée intérieure 210, et donc une même région de grille 214 et un même élément conducteur 211, avec une cellule de transistor centrale 21 adjacente dans la direction Y. Chaque cellule de transistor latérale 42 comporte en outre une au moins une partie latérale d'une tranchée extérieure 220.

Des cellules de transistor centrales 21 adjacentes dans la direction Y peuvent également partager de mêmes contacts de grille, de source et de drain 234, 235, 237, et des cellules de transistor centrales et latérales 21, 42 adjacentes dans la direction Y peuvent partager un même contact de grille 234, mais d'autres configurations peuvent être envisagées par la personne du métier.

La structure de transistor de détection 400 de la figure 4A est intégrée en parallèle avec une structure principale de transistor dans le dispositif électronique, par exemple dans la région principale de transistor 110 du dispositif électronique 100 des figures 1A et 1B. De préférence, les grilles, respectivement les drains, des MOSFET de la structure principale de transistor sont court-circuitées avec les grilles, respectivement les drains, des MOSFET de la structure de transistor de détection.

La figure 5 montre des courbes qui représentent la dérive du courant en fonction de la température dans une cellule de transistor latérale d'une structure de transistor de détection selon un mode de réalisation, comparée à une structure de transistor de détection de l'état de l'art. La courbe 501 représente la structure de transistor de détection de l'état de l'art. La courbe 502 représente la structure du transistor de détection selon un mode de réalisation.

Comme cela est représenté dans la figure 5, la dérive du courant K_{drift} est d'environ -3 % ou plus pour la structure de transistor de détection de l'état de l'art, alors que la dérive du courant K_{drift} est d'environ 0,2 % ou même moins pour la structure de transistor de détection selon un mode de réalisation.

Par conséquent, les inventeurs ont déterminé que la structure de transistor de détection selon un mode de réalisation permet de réduire de façon très efficace la dérive du courant dans les cellules de transistor latérales, et que la structure de transistor de détection peut avoir un courant représentatif du courant de la structure principale de transistor dans une large plage de températures, par exemple entre -40 et 150°C.

La structure de transistor de détection peut être utilisée pour détecter une surtension, un court-circuit, une charge ouverte ou d'autres conditions dangereuses pouvant survenir sur la structure principale de transistor.

Les modes de réalisation décrits ci-dessus sont particulièrement adaptés pour être utilisés dans tout type de marché industriel où la détection d'un courant de transistor est nécessaire, en particulier dans les marchés industriels utilisant des transistors de puissance.

Plus particulièrement, la structure de transistor de détection selon les modes de réalisation et le dispositif électronique selon les modes de réalisation, comprenant la structure de transistor de détection en parallèle avec une structure principale de transistor, peuvent être destinés à :
- l'industrie automobile, par exemple dans le domaine de l'électrification des voitures ou dans le domaine des systèmes avancés d'aide à la conduite ;
- l'industrie industrielle, par exemple dans le domaine de l'énergie verte, de l'électrification des infrastructures, de l'internet des objets (IoT, de l'anglais "Internet of Things") et des maisons intelligentes, où la consommation d'énergie et l'échange de données sont des éléments clefs ;
- l'industrie de l'électronique personnelle, par exemple dans le domaine de la téléphonie mobile et de l'internet des objets (IoT), et dans le domaine de l'interface à haut débit ; et
- l'industrie des équipements de communication, des ordinateurs et des périphériques.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les exemples sont décrits avec le premier type de conductivité de type N et le deuxième type de conductivité de type P, les MOSFET étant des transistors NMOS. Ceci n'est pas limitatif et la personne du métier saura modifier la structure pour des transistors PMOS, le premier type de conductivité étant alors le type P et le deuxième type de conductivité le type N. De plus, la personne du métier saura envisager des dispositifs électriques avec à la fois des transistors NMOS et PMOS.

Enfin, la mise en œuvre pratique des modes de réalisation et variantes décrits est à la portée de la personne du métier à partir des indications fonctionnelles données ci-dessus.

## Revendications

1. Structure de transistor de détection (400) dédiée à la détection d'un courant circulant dans une structure principale de transistor, la structure de transistor de détection comprenant une pluralité de cellules de transistor (21, 42) situées au moins dans des zones actives (23, 43) formées dans une première couche semiconductrice (203) d'un premier type de conductivité s'étendant dans un plan (XY), chaque cellule de transistor comprenant une région de drain à faible diffusion, LDD, (206, 406) du premier type de conductivité et une région de corps (204, 404) du deuxième type de conductivité opposé au premier type de conductivité ;
les régions LDD et de corps étant situées dans les zones actives, affleurant une première face (203A) de la première couche semiconductrice (203) et étant séparées les unes des autres dans une première direction (X) du plan, les zones actives (23, 43) étant séparées les unes des autres dans une deuxième direction (Y) du plan (XY), sensiblement orthogonale à la première direction (X), par des tranchées intérieures (210) s'étendant à partir de la première face (203A) dans la première couche semiconductrice (203) ;
les cellules de transistor comprenant :
- des premières cellules de transistor (42) situées sur des bords longitudinaux, s'étendant dans la première direction (X), de la structure de transistor de détection (400), chaque première cellule de transistor comprenant une première région de contact (409) dans une première région de corps (404) parmi les régions de corps, un premier contact (435) sur la première région de contact (409), et une première région LDD (406) parmi les régions LDD, la première région de contact (409) affleurant la première face (203A) et étant plus fortement dopée du deuxième type de conductivité que la première région de corps (404) ; et
- des deuxièmes cellules de transistor (21) positionnées entre les premières cellules de transistor (42) dans la deuxième direction (Y), chaque deuxième cellule de transistor comprenant une région de drain (207) implantée dans une deuxième région LDD (206) parmi les régions LDD, une région de source (205) implantée dans une deuxième région de corps (204) parmi les régions de corps, les régions de drain et de source étant implantées à partir de la première face (203A) et étant plus fortement dopées du premier type de conductivité que respectivement la deuxième région LDD et la deuxième région de corps, un contact de source (235) sur la région de source (205) et un contact de drain (237) sur la région de drain (207) ;
les cellules de transistor (21, 42) comportant en outre des régions de grille (214) dans les tranchées intérieures (210) entre les régions de corps (204, 404) adjacentes dans la deuxième direction (Y).

2. Structure de transistor de détection (400) selon la revendication 1, dans laquelle :
- les premières cellules de transistor (42) ne comportent ni régions de source dans les premières régions de corps (404), ni régions de drain dans les premières régions LDD (406) ; et/ou
- les premières cellules de transistor (42) ne comportent pas de contacts de drain sur les premières régions LDD (406).

3. Structure de transistor de détection selon la revendication 1 ou 2, dans laquelle les cellules de transistor (21, 42) sont allongées dans la première direction (X).

4. Structure de transistor de détection selon l'une quelconque des revendications 1 à 3, dans laquelle :
- chaque deuxième cellule de transistor (21) comprend en outre une deuxième région de contact (209) dans la deuxième région de corps (204), la deuxième région de contact (209) affleurant la première face (203A) et étant plus fortement dopée du deuxième type de conductivité que la deuxième région de corps (204) ; et/ou
- les deuxièmes cellules de transistor (21) adjacentes dans la deuxième direction (Y) ont une deuxième région de corps (204) commune, une région de source (205) commune, une deuxième région LDD (206) commune, une région de drain (207) commune et une région de grille (214) commune ; et
- les première et deuxième cellules de transistor (21, 42) adjacentes dans la deuxième direction (Y) ont une région de grille (214) commune.

5. Structure de transistor de détection (400) selon l'une quelconque des revendications 1 à 4, comprenant en outre une tranchée extérieure (220) située autour des zones actives (23, 43), et des tranchées intérieures (210) et reliée aux tranchées intérieures, la tranchée extérieure comportant un élément conducteur (221) entouré d'une couche isolante (222).

6. Structure de transistor de détection (400) selon l'une quelconque des revendications 1 à 5, dans laquelle la région de grille (214) est entourée dans chaque tranchée intérieure (210) d'une couche isolante de grille (215).

7. Structure de transistor de détection (400) selon l'une quelconque des revendications 1 à 6, dans laquelle chaque tranchée intérieure (210) comporte un élément conducteur (211) entouré d'une couche isolante (212), l'élément conducteur se trouvant sous la région de grille (214) entre les régions de corps (204, 404) adjacentes dans la deuxième direction (Y) et s'étendant jusqu'à la première face (203A) de la première région semiconductrice (203) entre les régions LDD (206, 406) adjacentes dans la deuxième direction (Y).

8. Structure de transistor de détection (400) selon les revendications 6 et 7, dans laquelle une partie isolante (216) est positionnée entre l'élément conducteur (211) et la région de grille (214) dans chaque tranchée intérieure (210), par exemple, la partie isolante est de la même épaisseur et/ou d'un même matériau que la couche isolante de grille (215).

9. Structure de transistor de détection (400) selon l'une quelconque des revendications 1 à 8, comprenant en outre une deuxième couche semiconductrice (202) du deuxième type de conductivité sous la première couche semiconductrice (203), par exemple entre la première couche semiconductrice (203) et un substrat semiconducteur (201) du premier type de conductivité ; les tranchées intérieures s'étendant par exemple jusqu'à la deuxième couche semiconductrice (202).

10. Structure de transistor de détection (400) selon l'une quelconque des revendications 1 à 9, dans laquelle :
- les tranchées intérieures (210) s'arrêtent dans la première couche semiconductrice (203) ; et/ou les cellules de transistor (21, 42) sont des cellules de transistor MOS à effet de champ à diffusion latérale en tranchée, TLDMOS.

11. Dispositif électronique (100) comprenant :
- une structure de transistor de détection (120 ; 400) selon l'une quelconque des revendications 1 à 10 ; et
- une structure principale de transistor (110) reliée en parallèle à la structure de transistor de détection.

12. Procédé d'utilisation d'une structure de transistor de détection (400) selon l'une quelconque des revendications 1 à 10 pour la détection d'un courant circulant dans une structure principale de transistor (110) reliée en parallèle avec la structure de transistor de détection, le procédé d'utilisation comprenant :
- la mesure d'un premier courant traversant la structure de transistor de détection (400) ; et
- la déduction à partir du premier courant d'un deuxième courant traversant la structure principale de transistor (110).

13. Procédé d'utilisation d'une structure de transistor de détection (400) pour la détection d'un courant circulant dans une structure principale de transistor (110), le procédé d'utilisation comprenant :
- le couplage de la structure de transistor de détection en parallèle avec la structure principale de transistor, dans lequel la structure de transistor de détection comprend une pluralité de premières cellules de transistor (42) et de deuxièmes cellules de transistor (21) situées dans des zones actives (23, 43) formées dans une première couche semiconductrice (203) d'un premier type de conductivité s'étendant dans un plan (XY), chacune des premières et deuxièmes cellules de transistor comprenant une région de drain à faible diffusion, LDD, (206, 406) du premier type de conductivité et une région de corps (204, 404) du deuxième type de conductivité opposé au premier type de conductivité ;
les régions LDD et de corps étant situées dans les zones actives (23) affleurant une première face (203A) de la première couche semiconductrice (203) et étant séparées les unes des autres dans une première direction (X) du plan, les zones actives (23, 43) étant séparées les unes des autres dans une deuxième direction (Y) du plan (XY), sensiblement orthogonale à la première direction (X), par des tranchées intérieures (210) s'étendant à partir de la première face (203A) dans la première couche semiconductrice (203) ;
les premières cellules de transistor (42) étant situées sur des bords longitudinaux, s'étendant dans la première direction (X), de la structure de transistor de détection (400), chaque première cellule de transistor comprenant une première région de contact (409) dans une première région de corps (404) parmi les régions de corps, un premier contact (435) sur la première région de contact (409), et une première région LDD (406) parmi les régions LDD, la première région de contact (409) affleurant la première face (203A) et étant plus fortement dopée du deuxième type de conductivité que la première région de corps (404) ; et les deuxièmes cellules de transistor (21) étant positionnées entre les premières cellules de transistor (42) dans la deuxième direction (Y), chaque deuxième cellule de transistor comprenant une région de drain (207) implantée dans une deuxième région LDD (206) parmi les régions LDD, une région de source (205) implantée dans une deuxième région de corps (204) parmi les régions de corps,
les régions de drain et de source étant implantées à partir de la première face (203A) de la première couche semiconductrice (203) et étant plus fortement dopées du premier type de conductivité que respectivement la deuxième région LDD et la deuxième région de corps, un contact de source (235) sur la région de source (205) et un contact de drain (237) sur la région de drain (207) ;
- l'utilisation de régions de grille (214) situées dans les tranchées intérieures (210) entre les régions de corps (204, 404) adjacentes dans la deuxième direction (Y) pour commander un premier courant dans les premières et deuxièmes cellules de transistor, permettant ainsi une reproduction précise d'un deuxième courant circulant dans la structure principale de transistor ; et
- la mise en œuvre d'une étape de rétroaction basée sur le premier courant détecté par la structure de transistor de détection pour régler le fonctionnement de la structure principale de transistor, empêchant ainsi des conditions de surintensité et améliorant la sécurité et la fiabilité de la structure principale de transistor.

14. Procédé de fabrication d'une structure de transistor de détection (400) dédiée à la détection d'un courant circulant dans une structure principale de transistor (110), le procédé de fabrication comprenant :
- la formation de tranchées intérieures (210) à partir d'une première face (203A) et à travers une couche semiconductrice (203) d'un premier type de conductivité s'étendant dans un plan (XY), ayant une première direction (X) et une deuxième direction (Y) sensiblement orthogonale à la première direction, formant ainsi, dans la couche semiconductrice, des zones actives (23, 43) séparées les unes des autres dans la deuxième direction (Y) par les tranchées intérieures ;
- la formation, dans les zones actives (23, 43), d'une pluralité de premières cellules de transistor (42) sur des bords longitudinaux, s'étendant dans la première direction (X), de la structure de transistor de détection (400) et de deuxièmes cellules de transistor (21) entre les premières cellules de transistor (42) dans la deuxième direction (Y) ;
dans lequel la formation des premières et deuxièmes cellules de transistor comprend :
la formation, dans chacune des premières et deuxièmes cellules de transistor et dans les zones actives (23, 43), d'une région LDD (206, 406) du premier type de conductivité et d'une région de corps (204, 404) du deuxième type de conductivité opposé au premier type de conductivité, chacune affleurant la première face (203A) et séparée l'une de l'autre dans la première direction (X) ;
l'implantation, dans chacune des premières cellules de transistor, d'une première région de contact (409) affleurant la première face (203A) dans une première région de corps (404) parmi les régions de corps, avec un dopage du deuxième type de conductivité plus important que la première région de corps, et la formation d'un premier contact (435) sur chaque première région de contact ;
l'implantation, dans chacune des deuxièmes cellules de transistor, d'une région de drain (207) affleurant la première face (203A) dans une deuxième région LDD (206) parmi les régions LDD, avec un dopage du premier type de conductivité plus important que celui de la deuxième région LDD, et d'une région de source (205) affleurant la première face (203A) dans une deuxième région de corps (204) parmi les régions de corps avec un dopage plus important du premier type de conductivité que la deuxième région de corps, et la formation d'un contact de source (235) sur la région de source et un contact de drain (237) sur la région de drain ;
- l'intégration de régions de grille (214) dans les tranchées intérieures (210) entre les régions de corps (204, 404) adjacentes dans la deuxième direction (Y) pour commander l'état de conduction des premières et deuxièmes cellules de transistor.

15. Procédé de fabrication selon la revendication 14, comprenant en outre le montage de la structure de transistor de détection (400) en parallèle avec la structure principale de transistor (110), le couplage électrique des régions de grille des structures de transistor de détection et principal entre elles et le couplage électrique des régions de drain des structures de transistor de détection et principal entre elles pour faciliter la détection du courant et la protection de la structure principale de transistor.
